# EUROPEAN PATENT APPLICATION

(11) **EP 3 349 552 A1**
(43) Date of publication of application: **18.07.2018**
(21) Application number: 18151449.8
(22) Date of filing: 12.01.2018
(51) Int. Cl.: H05K 1/18, H01L 23/538, H05K 3/46

(54) **EMBEDDING COMPONENT IN COMPONENT CARRIER BY RIGID TEMPORARY CARRIER**

(30) Priority: 13.01.2017 CN 201720043126 U
(71) Applicant: At&S (China) Co., Ltd., Shanghai 201108 (CN)
(72) Inventor: Tuominen, Mikael, Shanghai, 201108 (CN); Tay, Annie, 738202 Singapore (SG); Abderrazzaq, Ifis, Shanghai, 200030 (CN)
(74) Representative: Dilg, Haeusler, Schindelmann Patentanwaltsgesellschaft mbH

(57) **Abstract**

A semifinished product (100) for manufacturing a component carrier (102), wherein the semifinished product (100) comprises a base structure (104) having a recess (106), a rigid temporary carrier (108) on which the base structure (104) is mounted, and a component (110) mounted in the recess (106).

## Description

The invention relates to a semifinished product and to a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, efficiently embedding a component in a component carrier is an issue.

It is an object of the invention to efficiently embed a component in a component carrier.

In order to achieve the object defined above, a semifinished product and a component carrier according to the independent claims are provided.

According to an exemplary embodiment of the invention, a semifinished product for manufacturing a component carrier is provided, wherein the semifinished product comprises a base structure (such as a core, which may for instance be made of fully cured material such as FR4) having a recess (in particular a through extending fully through the base structure and being closed at a bottom side by the later mentioned temporary carrier), a rigid temporary carrier on which the base structure is mounted, and a component mounted in the recess.

According to another exemplary embodiment of the invention, a method of manufacturing a component carrier is disclosed, wherein the method comprises providing a base structure having a recess, mounting the base structure on a rigid temporary carrier, mounting an electronic component in the recess, and removing the rigid temporary carrier after interconnecting, in particular laminating, electrically insulating material to the base structure and the component.

According to still another exemplary embodiment of the invention, a component carrier is provided which is manufactured using a semifinished product having the above mentioned features and/or by a manufacturing method having the above mentioned features.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "semifinished product" may particularly denote a structure which is not yet a readily finished component carrier, but in contrast to this is a pre-form thereof obtained during manufacture of a component carrier. Such a semifinished product may still comprise the temporary carrier which is to be removed from the rest of the component carrier or a pre-form thereof later during the manufacturing process. However, the temporary carrier provides temporarily mechanical support as long as the pre-form of the component carrier is not yet in a configuration in which it can support itself without its various elements being prone to changing their relative positions to one another before mutual fixation or interconnection.

In the context of the present application, the term "temporary carrier" may particularly denote a body connected to a pre-form of a component carrier only during manufacturing the component carrier, wherein this body is removed from the manufactured component carrier or a pre-form thereof prior to the first use of the component carrier. Thus, the temporary carrier does not form part of the readily manufactured component carrier during its actual use or operation.

In the context of the present application, the term "rigid temporary carrier" may particularly denote a temporary carrier which shows sufficient stiffness or rigidity so that it is not prone to bending or pronounced elastic deformation. In particular, the rigid temporary carrier may be substantially inflexible. Thus, a rigid temporary carrier is very different from an easily bendable sticky tape which is conventionally used as temporary carrier.

According to an exemplary embodiment of the invention, a component is embedded in a recess of a base structure of component carrier material supported from a bottom side by a rigid temporary carrier. Thus, a through-hole through the base structure may be closed at a bottom side to thereby define the recess by the rigid temporary carrier which is attached to the base structure only temporarily, i.e. does not form part of the readily manufactured component carrier. By having a rigid temporary carrier, mechanical stability and positional accuracy of both the base structure and the component to be embedded may be ensured over the entire manufacturing procedure with high precision. Furthermore, conventionally occurring issues with undesired stretching or bending of a flexible tape (which is conventionally used for embedding purposes) may be dispensable according to exemplary embodiments of the invention, since this may be prevented by the stiff property of the temporary carrier. Thus, a highly reliable component carrier can be manufactured as a result of the obtainable high registration accuracy.

In the following, further exemplary embodiments of the semifinished product, the component carrier and the method of manufacturing a component carrier will be explained.

In an embodiment, the rigid temporary carrier has an adhesive surface facing the base structure and the component. By such an adhesive surface of the rigid temporary carrier, a temporary connection or adhesion between the base structure on the one hand and the rigid temporary carrier on the other hand may be accomplished. Also, such adhesive may keep the component mounted in the recess or cavity before being permanently fixed there, for instance by further adhesive and/or an electrically insulating layer structure being cured by lamination (for instance by the application of temperature and/or pressure).

In an embodiment, the rigid temporary carrier is configured for being removable from the base structure and the component after such a lamination procedure. After lamination, an obtained body composed of base structure, component and one or more electrically insulating and/or conductive layer structure(s) may have a sufficient intrinsic stability so that it is no more required to maintain the rigid temporary carrier attached to the latter mentioned elements of the component carrier to be manufactured. It is then possible to remove this pre-form of the component carrier from the rigid temporary carrier.

In an embodiment, the rigid temporary carrier is configured for being removable from the base structure and the component upon supply of at least one of the group consisting of heat and ultrasonic sound. The provision of heat and/or ultrasonic sound is a non-invasive method of separating the rigid temporary carrier from the rest of the component carrier under manufacture. However, it is alternatively also possible to remove the rigid temporary carrier from the rest of the component carrier under manufacture by a chemical treatment which dissolves the two elements from one another. Furthermore, it is possible that the two components are mechanically separated, for instance by inserting a wedge-shaped separation tool in between. Alternatively, this can for instance be accomplished by simply detaching or peeling off the rigid temporary carrier from the rest of the component carrier under manufacture.

In an embodiment, the rigid temporary carrier is configured as a reusable rigid temporary carrier to be attached to another base structure and another component after removal from the base structure and the component. Thus, it is possible to recycle or use the rigid temporary carrier multiple times again to temporarily attach or support elements of a respective component carrier under manufacture. Due to the rigid character of the rigid temporary carrier it may be possible that the entire rigid temporary carrier can be reused or that only the adhesive layer on a top surface thereof is replaced by a new one after one or several temporary attachment cycles. This reduces the ecological footprint and simplifies the manufacturing process.

In an embodiment, the rigid temporary carrier has a thickness of less than 80 µm, in particular of less than 50 µm. Thus, the thickness of the rigid temporary carrier may be very small. This keeps the effort for manufacturing the rigid temporary carrier small and allows to handle it easily due to a light weight. Furthermore, also the costs for such a rigid temporary carrier are small. The rigid temporary carrier may be formed with easily available ad cheap materials, such as FR4 or copper, being also properly compatible with component carrier manufacture technology. Using such materials also keeps thermal mismatch small during a lamination procedure during which the temperature can be increased.

In an embodiment, the base structure (such as a core) is made of fully cured material, in particular FR4. In the context of the present application, the term "fully cured material" may particularly denote material which does not re-melt or become flowable during a lamination procedure. Therefore, when the arrangement of base structure and component are laminated together with at least one electrically insulating layer structure and/or at least one electrically conductive layer structure by lamination, the base structure as well as the component in the recess of the base structure remain at a well-defined spatial position. This allows to ensure a high spatial precision. In contrast to this, in particular at least one electrically insulating layer structure to be laminated with the arrangement of base structure and component on the rigid temporary carrier may re-melt during the lamination procedure and may cover an upper surface of base structure and component, optionally may additionally fill a gap between base structure and component in the recess.

In an embodiment, the rigid temporary carrier (in particular a rigid support plate thereof) is made of a fully cured material, in particular FR4. In this context, the term "fully cured" may particularly denote a material property according to which the corresponding material (such as resin) is not capable any more of being re-melted to become flowable and of being subsequently re-solidified. In particular, resin material of the fully cured temporary carrier may be already cross-linked. Thus, the fully cured temporary carrier may be C-stage material rather than A-stage or B-stage material. This provides a very high degree of rigidity, since the rigid temporary carrier is prevented from remelting or becoming flowable during lamination of the base structure and the component with laminable material such as prepreg or liquid resin.

In another embodiment, the rigid temporary carrier is made of an at least partially uncured material, in particular prepreg. In the context of the present application, the term "at least partially uncured material" may particularly denote material which becomes re-flowable during a lamination procedure, i.e. by the application of temperature and/or pressure. For example, such a material may be a resin which is still non-cross-linked. For instance, an electrically insulating layer structure having such material properties is resin, in particular epoxy resin, optionally comprising particles therein, for instance fibres. For example, such fibres may be glass fibres reinforcing the material. It is therefore possible in the described embodiment that the rigid temporary carrier is hardened or further hardened during the lamination procedure.

In an embodiment, the rigid temporary carrier comprises a rigid, in particular non-adhesive, support plate and an adhesive layer or sheet applied onto the support plate. The configuration of a rigid temporary carrier as a two-layer structure allows to optimize both individual layers in terms of their respective function. The support plate may function as a stiff support body providing mechanical support to the base structure and the component during a lamination procedure to achieve high registration accuracy. The adhesive layer may temporarily fix the support plate to the base structure and to the component before component and base structure are interconnected to one another with sufficient mechanical stability, in particular by lamination procedure.

In an embodiment, the support plate has a thickness in a range between 10 µm and 200 µm. Thus, the support plate may be manufactured in a lightweight, simple and cheap way.

In an embodiment, the adhesive layer has a thickness in a range between 2 µm and 20 µm. Therefore, the adhesive layer can be manufactured in a lightweight, simple and cheap way.

In an embodiment, the semifinished product further comprises a filling medium in a gap between the base structure and the component in the recess or cavity. Such a filling medium may for instance be resin filling the gap and being cured during a lamination procedure. Alternatively, the filling material may be part of an electrically insulating layer structure which is laminated to the base structure and component while still being placed on the rigid temporary carrier and flowing into the gap during the lamination. The filling medium may also support the base structure, the component and a further at least one electrically insulating layer structure and/or at least one electrically conductive layer structure in fixing the component within the component carrier under manufacture at a well-defined position and in a stable way and protected way.

In an embodiment, the filling medium has one or more properties of an adhesive property (i.e. acting as glue), a heat removal property, an electromagnetic radiation shielding property, and an electrically conductive property. Advantageously, the filling medium itself may provide at least one further function which can be provided by filler particles of the filling medium. In one embodiment, such filler particles may be made of highly thermally conductive material such as graphene particles, DLC (Diamond-Like Carbon) particles, or glass particles covered with a thermally highly conductive cover layer. It is also possible that the filler particles provide an electromagnetic radiation shielding function so as to shield the electromagnetic radiation propagating from the embedded component to an exterior thereof, and/or from an exterior into the component. Therefore, the filling medium may also provide for an EMI (electromagnetic interference) protection. This can be accomplished for instance by electrically conductive or magnetic (in particular ferromagnetic) filler particles. When being made of electrically conductive material (for instance copper, nickel, aluminum, iron) the filler particles may also provide for an electric connection of the embedded component.

In an embodiment, the filling medium (more particular filler particles thereof) comprises at least one of the group consisting of electrically conductive paste, electrically conductive ink, an Anisotropic Conductive Film (ACF) and an Anisotropic Conductive Paste (ACP) electrically coupling the component with an electrically conductive layer structure of the component carrier and/or with an electronic periphery device. An ACF is an adhesive interconnect system in the shape of a film that is used to establish electrical and mechanical connections. ACF can be used alternatively in a paste form referred to as anisotropic conductive paste (ACP). By taking this measure, it is possible to design any desired electric interconnection between the component and an environment.

In an embodiment, the semifinished product comprises at least one electrically conductive layer structure and/or at least one electrically insulating layer structure interconnected with, in particular laminated with, the base structure and the component on a side opposing the rigid temporary carrier. In particular, the layer structure(s) may be laminated only on this side, not on the opposing other side where the temporary carrier is still present.

Such material may however alternatively also be laminated on the temporary carrier side of base structure and component after removal of the temporary carrier (for instance to obtain a vertically symmetric structure, for efficiently suppressing warpage and delamination).

The at least one component can be selected from a group consisting of an electrically non-conductive inlay, an electrically conductive inlay (such as a metal inlay, preferably comprising copper or aluminum), a heat transfer unit (for example a heat pipe), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite base structure) or may be a paramagnetic element. However, the component may also be a further component carrier, for example in a board-in-board configuration. The component may be surface mounted on the component carrier and/or may be embedded in an interior thereof. Moreover, also other components may be used as component.

In an embodiment, the semifinished product or the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the semifinished product or the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the semifinished product or the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the semifinished product or the component carrier is a laminate-type body. In such an embodiment, the semifinished product or the component carrier is a compound of multiple layer structures which are stacked and connected together by applying a pressing force, if desired accompanied by heat.

It should be emphasized once again that all the above-mentioned embodiments may also be implemented in the method of manufacturing a component carrier according to an exemplary embodiment of the invention.

The aspects defined above and further aspects of the invention are apparent from the examples of embodiment to be described hereinafter and are explained with reference to these examples of embodiment.

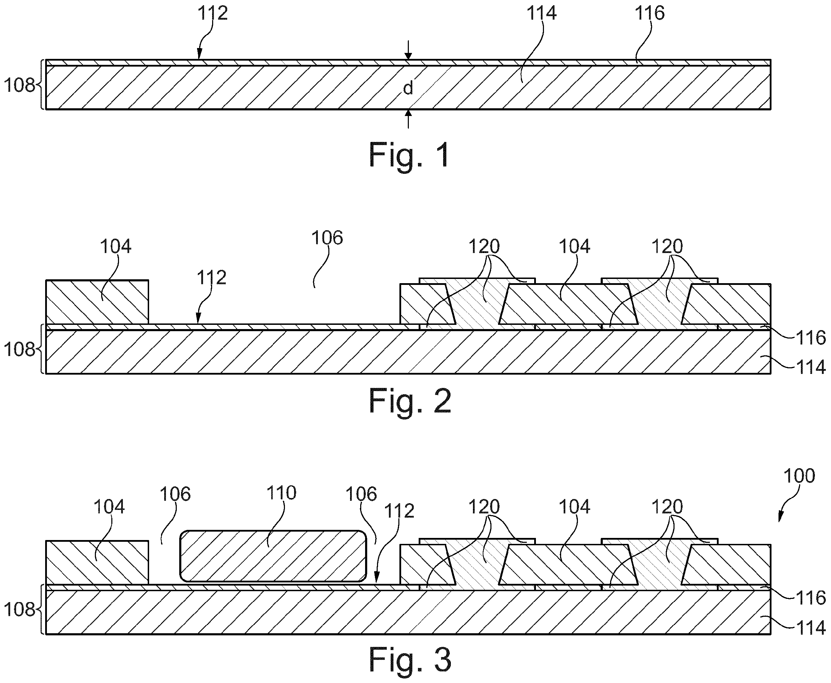

Figure 1 to Figure 6 illustrate cross-sectional views of semifinished products obtained during carrying out a method of manufacturing a component carrier and embedding a component therein according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a rigid support plate may be used as temporary carrier for embedding a component in a base structure of a component carrier under manufacture, wherein the rigid support plate may be covered with an adhesive layer.

In contrast to this, conventional approaches use a bendable sticky tape as a temporary carrier.

Contrary to conventional approaches and according to an exemplary embodiment of the invention, no issues concerning dimensional stability and stretching issues occur when a rigid temporary carrier is implemented for embedding a component in a recess of a base structure. Therefore, a corresponding component carrier can be manufactured with high reliability, a simple manufacturing process and low costs. Moreover, the positional accuracy of the component is extremely high and simple to achieve with such an architecture. By taking the described measures, a highly stable component placement may be achieved. It is also possible to get rid of tape stretching caused issues. Furthermore, dimensional stability of the embedded base structure package may be improved.

Figure 1 to Figure 6 illustrate cross-sectional views of semifinished products 100 obtained during carrying out a method of manufacturing a component carrier 102 and embedding a component 110 therein according to an exemplary embodiment of the invention.

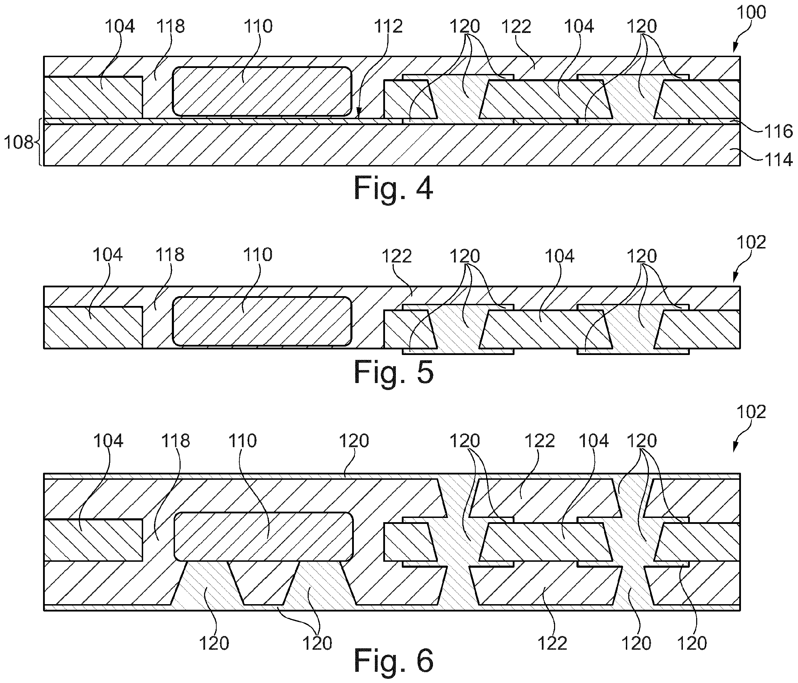

Referring to **Figure 1****,** a rigid temporary carrier 108 is provided with an adhesive surface 112. In the shown embodiment, the rigid temporary carrier 108 is configured for being attached to (compare Figure 2) and later removed from (compare Figure 5) a base structure 104 (compare Figure 2) and a component 110 (compare Figure 3). The rigid temporary carrier 108 may have a relatively small thickness, d, of for example 40 µm. More generally, its thickness, d, may be in a range between 10 µm and 1000 µm, in particular in a range between 20 µm and 250 µm. More specifically, the rigid temporary carrier 108 comprises a rigid non-adhesive support plate 114 and an adhesive layer 116 applied onto one main surface (according to Figure 1 the upper main surface) of the support plate 114. The support plate 114 may have a partial thickness of for instance 35 µm. Since the thickness, d, of the rigid temporary carrier 114 may be quite small, the rigid support plate 114 can be manufactured with low effort, low costs and with a light weight. In the shown embodiment, the support plate 114 of the rigid temporary carrier 108 is made of a fully cured material such as FR4. Thus, the support plate 114 may comprise fully cured epoxy resin in which reinforcing glass fibres are embedded. Moreover, the adhesive layer 116 may have a thickness of for example 5 µm and may for instance be made of an epoxy-based adhesive. Therefore, the entire thickness of the rigid temporary carrier 108 is very small, and nevertheless its function as rigid temporary carrier 108 is highly advantageous.

Figure 1 shows the result of a deposition of the adhesive layer 116 of typically 2 µm to 20 µm on the temporary support plate or carrier 108. The adhesion level can be in a range between 0.2 N/20mm and 15 N/20mm. The temporary support plate or carrier 108 may be made of glass, may be embodied as a FR4 dummy base structure, may be made of a metal, a plastic and/or a ceramic.

Referring to **Figure 2****,** base structure 104 (for instance a fully cured core) with a recess 106 is provided and attached to the adhesive layer 116 of the temporary carrier 108. As a result, the rigid temporary carrier 108 faces the adhesive layer 116 of the base structure 104. In the shown embodiment, the base structure 104 may be made of a fully cured material such as FR4, which does not loose structural stability during lamination.

As can be taken from Figure 2, the base structure 104 may be simply attached on a surface of the rigid temporary carrier 108 of Figure 1 without a lamination procedure. By rendering it possible to simply attach the two structures to one another, the manufacturing process is significantly simplified over a conventional process using a sticky tape which needs to be laminated on base structure 104. As can be taken from Figure 2, a plurality of electrically conductive layer structures 120 may already be implemented in the base structure 104 of fully cured material (for instance of FR4). The electrically conductive layer structures 120 may be copper structures. The electrically conductive layer structures 120 may comprise one or more patterned metal foils and may comprise vertical interconnects such as copper vias. As can furthermore be taken from Figure 2, recess 106, here configured as a through-hole, of the base structure 104 may be closed at its bottom by the rigid temporary carrier 108 to thereby delimit a spatially well-defined cavity. The adhesion between the base structure 104 and the rigid temporary carrier 108 is accomplished by the adhesive layer 116.

Summarizing, Figure 2 shows placement of the structured base structure 104 on the temporary support plate or carrier 108.

Referring to **Figure 3****,** an electronic component 110 (for instance a semiconductor chip) is mounted in the recess 106 and is attached to the exposed portion of the adhesive layer 116. The rigid temporary carrier 108 provides support for the component 110 before it is rigidly connected to the rest of the component carrier 102 under manufacture by lamination (compare Figure 4).

As a result, a semifinished product 100 according to an exemplary embodiment of the invention is obtained. The semifinished product 100 shown in Figure 3 is the basis for the formation or manufacture of a component carrier 102 according to an exemplary embodiment of the invention. The illustrated semifinished product 100 is composed of the base structure 104 with the recess 106, the rigid temporary carrier 108 on which the base structure 104 is mounted, and the component 110 mounted in the recess 106. The component carrier 102 to be manufactured from the semifinished product 100 is plate-shaped and is configured as a printed circuit board (PCB). As will be explained below referring to Figure 4 to Figure 6, the component carrier 102 is a laminate-type component carrier 102.

As can be taken from Figure 3, component 110 is placed in the cavity or bottom closed recess 106. Due to the adhesive effect of the adhesive layer 116, the component 110 is fixed in place at a well-defined position within the recess 106. At the shown stage of the manufacturing process, the base structure 104 and the component 110 do not yet form a sufficiently stable structure to stay in place without the supporting function of the rigid temporary carrier 108. However, due to the presence of the rigid temporary carrier 108, high mechanical support is given to both the base structure 104 and the component 110. No issues with bending of the rigid temporary carrier 108 occur because the latter provides a mechanically stable and stiff support. This has a further positive impact on positional accuracy of the arrangement shown in Figure 3.

Concluding, Figure 3 shows the placement of the component 110 on the temporary support plate or carrier 108 and its accommodation in the recess 106.

Referring to **Figure 4****,** at least one electrically insulating layer structure 122 of at least partially uncured material (for instance B-stage material such as resin) is placed on an upper main surface of the semifinished product 100 shown in Figure 3. Thereafter, pressure is applied to the so obtained structure, optionally accompanied by elevated temperature. As a consequence, the layer stack shown in Figure 4 is interconnected to one another by lamination and is thereby rendered rigid. During this lamination, flowable resin of the at least one electrically insulating layer structure 122 flows into the gaps shown in Figure 3 and interconnects and stabilizes the shown constituents. The flowable resin constitutes a filling medium 118 in a gap between the base structure 104 and the component 110 in the cavity 106. The filling medium 118 may function for stabilizing and interconnecting the various constituents of the component carrier 102 under manufacture.

However, the filling medium 118 (in particular when being applied separately from and before adding the at least one electrically insulating layer structure 122) may advantageously additionally provide one or more functional properties to the component carrier 102 under manufacture. Such properties may be an adhesive property, a heat removal property, an electromagnetic radiation shielding property, an electrically conductive property, etc.

In order to obtain the structure shown in Figure 4, the structure shown in Figure 3 is made subject of a lamination procedure. More precisely, the at least one electrically insulating layer structure 122 (optionally also at least one further electrically conductive layer structure 120) is laminated on top of the structure shown in Figure 3. The electrically insulating layer structure 120 can be made, prior to the lamination, of an at least partially uncured material such as prepreg. A partially uncured material may for instance comprise a resin or other polymer which has the capability of cross-linking upon application of heat and/or pressure. During this lamination procedure, the curable material of the at least one electrically insulating layer structure 122 re-melts or becomes flowable so that it also flows in the gaps between the component 110 and the base structure 104, i.e. into the recess 106. Thereby, the component 110 becomes spatially fixed at the defined position within the recess 106 after curing of the curable material of the at least one electrically insulating layer structure 122, which thereby becomes a fully cured electrically insulating layer structure 122.

The described procedure results in a filling of the previous cavity 106 with filling medium 118 and a stiffening of the component carrier 102 under manufacture. During this procedure, the cavity 106 is partly or completely filled with resin or adhesive or similar material. The filling can be done by dispensing, screenprinting, direct lamination, jet ink printing, coating, PVD (physical vapor deposition), etc.

Referring to **Figure 5****,** the rigid temporary carrier 108 is removed from the rest of the semifinished product 100 which is now, i.e. after the lamination described referring to Figure 4, stiff enough to hold together without the temporary carrier 108. This removal of the rigid temporary carrier 108 from the base structure 104 and the component 110 may be promoted by applying ultrasound, by heating or by a chemical and/or mechanical treatment.

The rigid temporary carrier 108 may be configured as a reusable rigid temporary carrier 108 which may be attached to another base structure 104 and another component 110 (not shown) after removal from the base structure 104 and the component 110 shown in Figure 4.

After the lamination procedure described referring to Figure 4, the arrangement of Figure 4 becomes mechanically sufficiently stable so as to keep in place and refrain from undesired bending even without the rigid temporary carrier 108. As can be taken from Figure 5, the rigid temporary carrier 108 can now be removed from the rest of the component carrier 102 under manufacture. Figure 5 therefore shows the result of the removal of the temporary support plate or carrier 108.

In order to obtain the component carrier 102 shown in **Figure 6****,** the structure shown in Figure 5 is made subject to a further lamination procedure on both of its upper main surface and its lower main surface. More precisely, at least one further electrically insulating layer structure 122 and at least one further electrically conductive layer structure 120 are connected and laminated on both of the two opposing main surfaces of the structure shown in Figure 5. Thereby, substantially any desired component carrier 102 with any desired number of layers and electronic functionality may be provided. In order to expose contacts (such as pads) of the embedded component 110, it is possible to drill laser holes from a lower main surface of the structure shown in Figure 6 and to expose the pads. Thereafter, the laser vias may be filled with electrically conductive material, for instance by copper plating, to obtain the readily manufactured component carrier 102 as shown in Figure 6. Figure 6 therefore shows the result of the process of finalizing the lamination and electrical connections.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A semifinished product (100) for manufacturing a component carrier (102), wherein the semifinished product (100) comprises:
a base structure (104) having a recess (106);
a rigid temporary carrier (108) on which the base structure (104) is mounted;
a component (110) mounted in the recess (106).

2. The semifinished product (100) according to claim 1, wherein the rigid temporary carrier (108) has an adhesive surface (112) facing the base structure (104) and the component (110).

3. The semifinished product (100) according to claim 1 or 2, wherein the rigid temporary carrier (108) is configured for being removable from the base structure (104) and the component (110) after a lamination procedure.

4. The semifinished product (100) according to one of the claims 1 to 3, wherein the rigid temporary carrier (108) is configured for being removable from the base structure (104) and the component (110) upon supply of at least one of the group consisting of heat and ultrasonic sound.

5. The semifinished product (100) according to one of the claims 1 to 4, wherein the rigid temporary carrier (108) is configured as a reusable rigid temporary carrier (108) to be attached to another base structure (104) and another component (110) after removal from the base structure (104) and the component (110).

6. The semifinished product (100) according to one of the claims 1 to 5, wherein the rigid temporary carrier (108) has a thickness of less than 80 µm, in particular of less than 50 µm.

7. The semifinished product (100) according to one of the claims 1 to 6, wherein the base structure (104) is made of fully cured material, in particular FR4.

8. The semifinished product (100) according to one of the claims 1 to 7, wherein the rigid temporary carrier (108) is made of one of the group consisting of a fully cured material, in particular FR4, and an at least partially uncured material, in particular prepreg.

9. The semifinished product (100) according to one of the claims 1 to 8, wherein the rigid temporary carrier (108) comprises a rigid, in particular non-adhesive, support plate (114) and an adhesive layer (116) applied onto the support plate (114),
wherein the support plate (114) has in particular a thickness in a range between 10 µm and 200 µm and/or
wherein the adhesive layer (116) has in particular a thickness in a range between 2 µm and 20 µm.

10. The semifinished product (100) according to one of the claims 1 to 9, further comprising a filling medium (118) in a gap between the base structure (104) and the component (110) in the recess (106).

11. The semifinished product (100) according to claim 10, wherein the filling medium (118) has at least one property of the group consisting of an adhesive property, a heat removal property, an electromagnetic radiation shielding property, and an electrically conductive property.

12. The semifinished product (100) according to one of the claims 1 to 11, comprising at least one electrically conductive layer structure (120) and/or at least one electrically insulating layer structure (122) interconnected with, in particular laminated with, the base structure (104) and the component (110) on a side, in particular only on a side, opposing the rigid temporary carrier (108).

13. The semifinished product (100) according to claim 12, wherein the at least one electrically conductive layer structure (120) comprises at least one of the group consisting of copper, aluminum, nickel, silver, gold, palladium, and tungsten, any of the mentioned materials being optionally coated with supra-conductive material such as graphene and/or
wherein the at least one electrically insulating layer structure (122) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide.

14. The semifinished product (100) according to one of the claims 1 to 13, wherein the component (110) is selected from a group consisting of an electronic component, an electrically non-conductive and/or electrically conductive inlay, a heat transfer unit, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier (102) and a logic chip and/or
wherein the semifinished product (100) is shaped as a plate and/or
wherein the component carrier (102) to be manufactured from the semifinished product (100) is configured as one of the group consisting of a printed circuit board, and a substrate and/or
wherein the component carrier (102) to be manufactured from the semifinished product (100) is configured as a laminate-type component carrier (102).

15. A component carrier (102), manufactured using a semifinished product (100) according to one of the claims 1 to 14.
